# EUROPEAN PATENT APPLICATION

(11) **EP 1 699 082 A1**
(43) Date of publication of application: **06.09.2006**
(21) Application number: 06251097.9
(22) Date of filing: 01.03.2006
(51) Int. Cl.: H01L 27/146, H01L 31/0203

(54) **Solid-state image sensing device**

(30) Priority: 02.03.2005 JP 2005058128
(71) Applicant: SHARP KABUSHIKI KAISHA, Osaka-shi, Osaka 545-8522 (JP)
(72) Inventor: Tsukamoto, Hiroaki, Yamatotakada-shi Nara 635-0045 (JP); Hirosumi, Nobuhito, Fukuyama-shi Hiroshima 721-0924 (JP); Yasudome, Takashi, Fukuyama-shi Hiroshima 721-0907 (JP); Kinoshita, Kazuo, Nara-shi, Nara 630-8307 (JP)
(74) Representative: Brown, Kenneth Richard

(57) **Abstract**

A solid-state image sensing device has a printed board (2); a solid-state image sensing element (13) fixed to the printed board (2); and a light-transmitting lid section (17) fixed to the solid-state image sensing element (13) so as to cover an image sensing area (effective pixel area) (14). The printed board (2) has a bore (8) which penetrates through the printed board (2) in a thickness direction thereof, at least a part of the light-transmitting lid section (17) is fitted in the bore (3), and connecting terminals (9) of the printed board (2) are connected to connecting terminals (15) of the solid-state image sensing element (13).

## Description

### BACKGROUND OF THE INVENTION

### 1. Field of the Invention

The present invention relates to a solid-state image sensing device suitable as a component of an optical device module.

### 2. Description of Related art

As a conventional solid-state image sensing device, the one shown in Japanese Patent Application Laid Open No. 2004-296453 is known.

Specifically, a solid-state image sensing element, such as a CCD or a CMOS image sensor, is fixed on a printed board at an opposite surface of an image sensing area, and a light-transmitting lid section that covers the image sensing area of the solid-state image sensing element is fixed to the solid-state image sensing element through an adhesive layer. A plurality of connecting terminals of the printed board are connected to a plurality of connecting terminals of the solid-state image sensing element by wires.

There is a demand for reduction in the thickness of the conventional solid-state image sensing device.

### BRIEF SUMMARY OF THE INVENTION

The present invention has been made with the aim of solving the above problem, and it is an object of the present invention to provide a solid-state image sensing device which is made thinner than the conventional one by providing a bore in a printed board and allowing at least a part of a light-transmitting lid section to be fitted in the bore.

Another object of the present invention is to provide a solid-state image sensing device in which at least a part of a solid-state image sensing element is fitted in a bore of a printed board, whereby the protective function of the solid-state image sensing element is enhanced by the printed board.

Still another object of the present invention is to provide a solid-state image sensing device, the strength of which is increased by a sealing material.

Another object of the present invention is to provide a solid-state image sensing device in which at least a part of another electronic component is fitted in a bore, whereby the protective function of the electronic component is enhanced by a printed board.

Still another object of the present invention is to provide a solid-state image sensing device including an electronic component, the strength of which is increased by a sealing material.

To attain the above objects, the present invention employs the following means.

A solid-state image sensing device according to the present invention is a solid-state image sensing device, comprising: a printed board; a solid-state image sensing element fixed to the printed board; and a light-transmitting lid section fixed to the solid-state image sensing element so as to cover an image sensing area, wherein the printed board has a bore which penetrates through the printed board in a thickness direction thereof, at least a part of the light-transmitting lid section is fitted in the bore, and a connecting terminal of the printed board is connected to a connecting terminal of the solid-state image sensing element.

The solid-state image sensing device according to the present invention is characterized in that at an inner surface of the bore is formed a flat surface which is parallel to one side of the printed board and on which the connecting terminal of the printed board is provided, and the solid-state image sensing element is fixed to the flat surface.

The solid-state image sensing device according to the present invention is characterized in that a sealing material is filled in space provided between side surfaces of the solid-state image sensing element and the light-transmitting lid section, and the inner surface of the bore.

The solid-state image sensing device according to the present invention is characterized in that at an inner surface of the bore are formed two step-like flat surfaces which are parallel to one side of the printed board and on which connecting terminals of the printed board are provided respectively, the solid-state image sensing element is fixed to one of the flat surfaces that is further away from the one side, an electronic component is fixed to the other of the flat surfaces that is closer to the one side, and a connecting terminal of the electronic component is connected to the connecting terminal of the printed board.

The solid-state image sensing device according to the present invention is characterized in that a sealing material is filled in space provided between side surfaces of the electronic component and the light-transmitting lid section, and the inner surface of the bore.

According to the present invention, since at least a part of a light-transmitting lid section is fitted in a bore of a printed board, a solid-state image sensing device thinner than the conventional one can be obtained. In addition, since a connecting terminal of the printed board is connected to a connecting terminal of a solid-state image sensing element, a problem associated with a connection by wire bonding can be overcome.

According to the present invention, since at least a part of a solid-state image sensing element is fitted in a bore, the solid-state image sensing element can be protected by a printed board.

According to the present invention, the overall strength of a solid-state image sensing device can be increased by a sealing material.

According to the present invention, since at least a part of an electronic component is fitted in a bore, the electronic component can be protected by a printed board.

According to the present invention, the overall strength of a solid-state image sensing device including an electronic component can be increased by a sealing material.

The above and further objects and features of the invention will more fully be apparent from the following detailed description with accompanying drawings.

### BRIEF DESCRIPTION OF THE SEVERAL VIEWS OF THE DRAWINGS

FIG. 1 is a schematic vertical end view showing a first embodiment of the present invention;
FIG. 2 is a view when viewed from line II-II of FIG. 1;
FIG. 3 is a view when viewed from line III-III of FIG. 1;
FIG. 4 is a schematic vertical end view showing a second embodiment of the present invention; FIG. 5 is a view when viewed from line V-V of FIG. 4;
FIG. 6 is a view when viewed from line VI-VI of FIG. 4;
FIG. 7 is a schematic vertical end view showing a third embodiment of the present invention; and
FIG. 8 is a schematic vertical end view showing a fourth embodiment of the present invention.

### DETAILED DESCRIPTION OF THE INVENTION

Embodiments of the present invention will be explained below. The terms "above", "up", and "top" and "under" used in the explanation represent the top and bottom of the drawings.

### (First Embodiment)

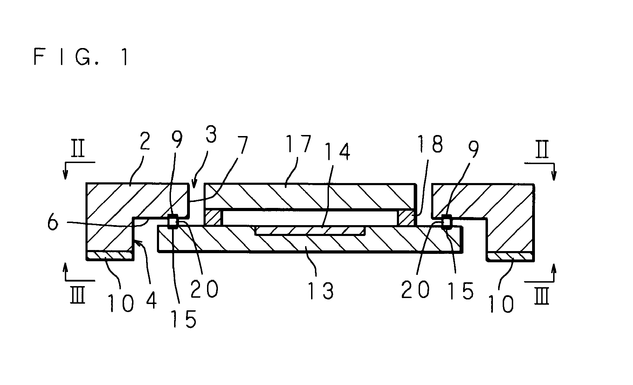

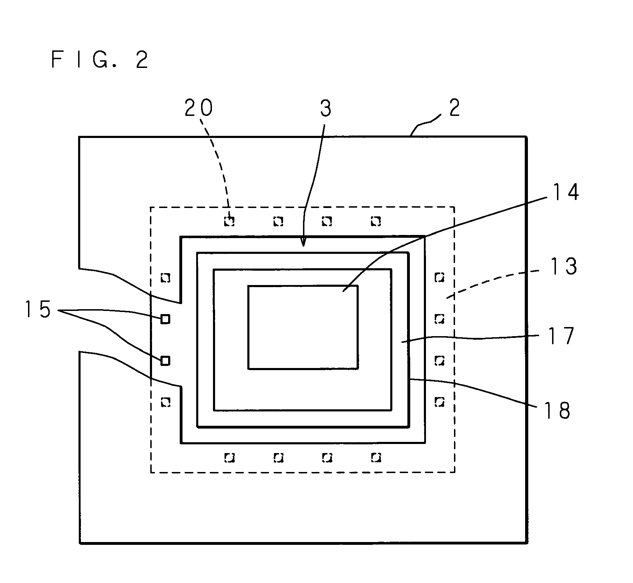

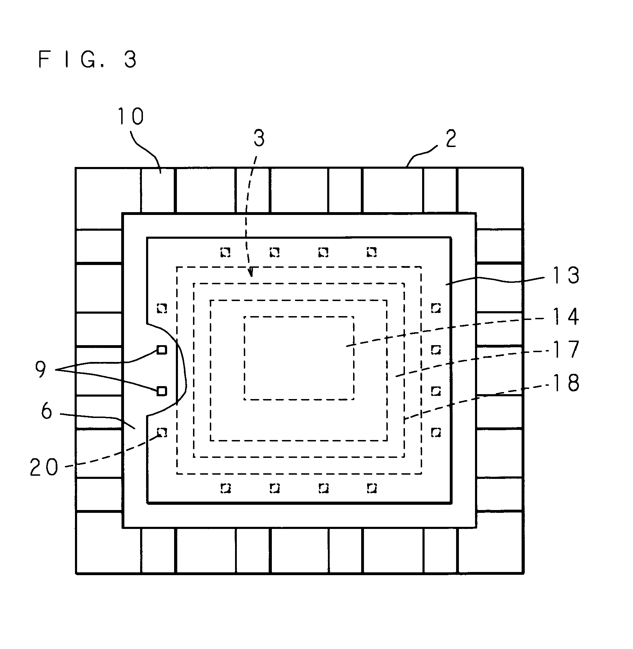

FIG. 1 is a schematic vertical end view showing a first embodiment of the present invention, FIG. 2 is a view when viewed from line II-II of FIG. 1, and FIG. 3 is a view when viewed from line III-III of FIG. 1. As shown in FIGS. 1 and 2, a bore 3 which is rectangular when viewed from the top is provided in the center of a printed board 2 which is rectangular when viewed from the top and which is provided with conductive wirings (not shown), so as to penetrate through the printed board 2 in a thickness direction thereof. At an inner surface 4 of the bore 3 is formed a step portion 7 having a flat surface 6 parallel to an under surface of the printed board 2. The form of the bore 3 when viewed from the top is in a size into which a light-transmitting lid section 17 fits. The form of the bore 3 when viewed from the bottom is in a size into which a solid-state image sensing element 13 fits. As shown in FIG. 3, a plurality of connecting terminals 9 are provided on the flat surface 6 with appropriate spacing therebetween. In addition, a plurality of connecting terminals 10 for establishing a connection to an external device are provided on the under surface of the printed board 2 with appropriate spacing therebetween. The connecting terminals 9 and 10 are connected to their corresponding conductive wirings on the printed board 2.

The connecting terminals 9 on the flat surface 6 of the printed board 2 are respectively connected, via bumps 20, to connecting terminals 15 provided on a periphery of a top side of the solid-state image sensing element 13 and opposed to the connecting terminals 9, by flip-chip bonding. By such a configuration, the solid-state image sensing element 13 is fixed to the flat surface 6. Examples of the solid-state image sensing element 13 include a CCD and a CMOS image sensor. Although the entire solid-state image sensing element 13 is fitted in the bore 3, only a part of the solid-state image sensing element 13 may be fitted in the bore 3. The solid-state image sensing element 13 is rectangular when viewed from the top. An image sensing area (effective pixel area) 14 which is rectangular when viewed from the top faces upward. The light-transmitting lid section 17 which is rectangular when viewed from the top covers the image sensing area 14 to protect the image sensing area 14 from dust, and has an optical filter function. The light-transmitting lid section 17 is fixed to the solid-state image sensing element 13 through an adhesive layer 18 provided on the top side of the solid-state image sensing element 13. The form of the light-transmitting lid section 17 when viewed from the top is greater than that of the image sensing area 14. The adhesive layer 18 is provided all around the periphery of the light-transmitting lid section 17. Although the entire light-transmitting lid section 17 is fitted in the bore 3, only a part of the light-transmitting lid section 17 may be fitted in the bore 3.

### (Second Embodiment)

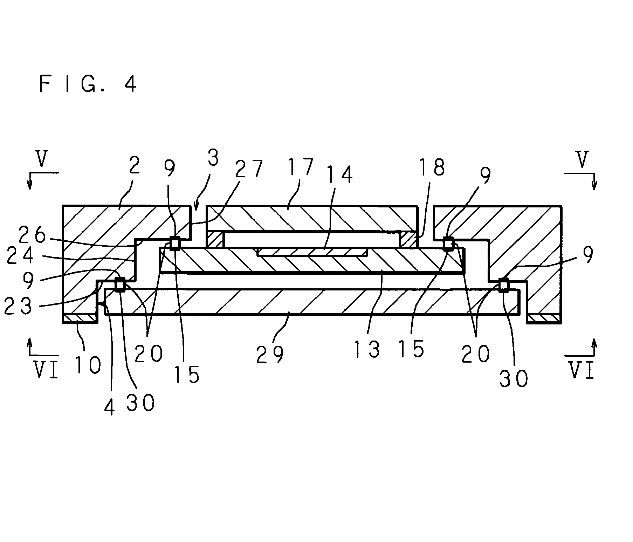

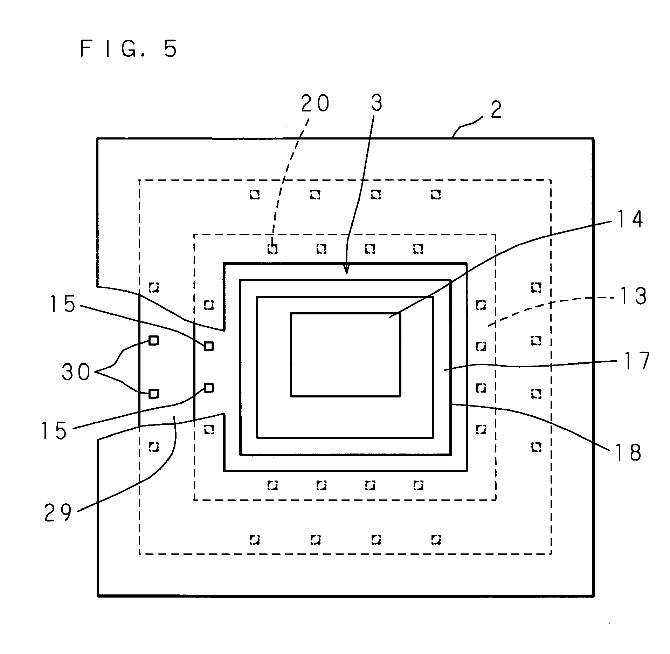

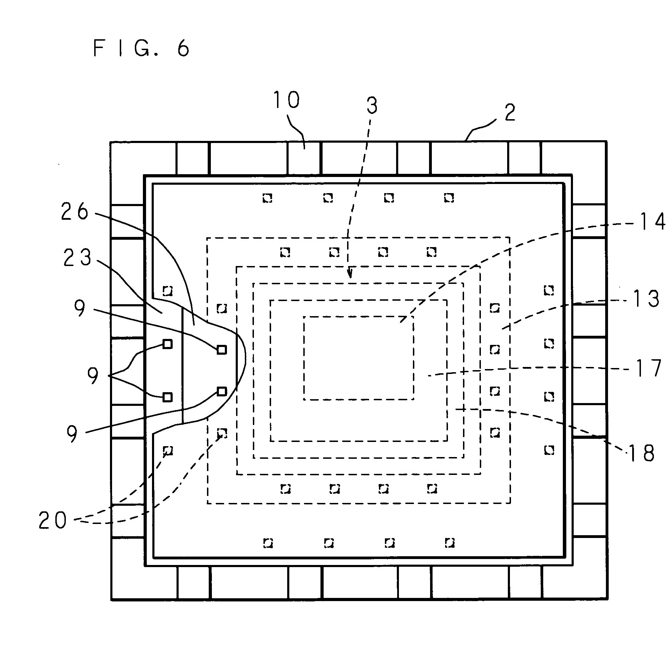

FIG. 4 is a schematic vertical end view showing a second embodiment of the present invention, FIG. 5 is a view when viewed from line V-V of FIG. 4, and FIG. 6 is a view when viewed from line VI-VI of FIG. 4. As shown in FIGS. 4 to 6, at an inner surface 4 of a bore 3 of a printed board 2 is formed a first step portion 24 having a first flat surface 23 which is parallel to an under surface of the printed board 2 and on which connecting terminals 9 of the printed board 2 is provided. In addition, at the inner surface 4 is formed a second step portion 27 having a second flat surface 26 which is parallel to the under surface of the printed board 2 and on which connecting terminals 9 of the printed board 2 is provided, such that the second step portion 27 is located above the first step portion 24.

A solid-state image sensing element 13 is opposed to the second flat surface 26 with a light-transmitting lid section 17 facing upward. The connecting terminals 9 on the second flat surface 26 are respectively connected, via bumps 20, to connecting terminals 15 of the solid-state image sensing element 13 that are opposed to the connecting terminals 9, by flip-chip bonding.

The connecting terminals 9 on the first flat surface 23 are respectively connected, via bumps 20, to connecting terminals 30 provided on a periphery of a top side of another electronic component 29 and opposed to the connecting terminals 9, by flip-chip bonding. By such a configuration, the electronic component 29 is fixed to the first flat surface 23 of the printed board 2. Examples of the electronic component 29 include a digital signal processor, a drive circuit for a CCD, a resistor for an external filter circuit, and a capacitor. The electronic component 29 is rectangular when viewed from the top. Also in the present embodiment, the entire light-transmitting lid section 17 and the entire electronic component 29 are fitted in the bore 3; however, only a part of the electronic component 29 may be fitted in the bore 3.

### (Third Embodiment)

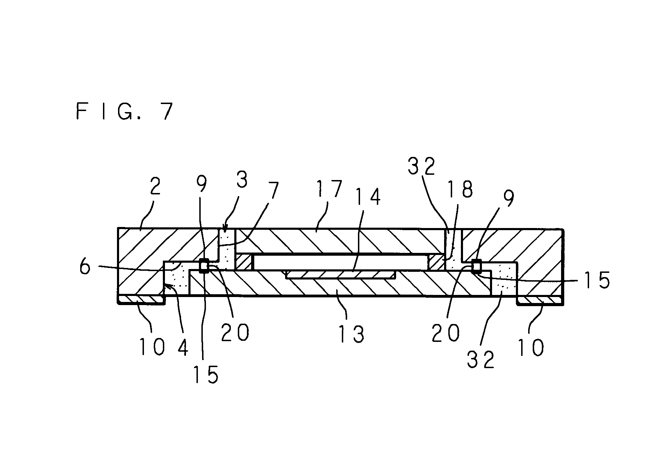

FIG. 7 is a schematic vertical end view showing a third embodiment of the present invention. As shown in FIG. 7, a sealing material 32 made of a synthetic resin is filled in space provided between side surfaces of a solid-state image sensing element 13, an outer surface of an adhesive layer 18, and side surfaces of a light-transmitting lid section 17, and an inner surface 4 of a bore 3. Other components are the same as those in the first embodiment; therefore, the same components are denoted by the same reference numerals and a detailed description thereof is omitted. The sealing material 32 protects bumps 20 and also increases the overall strength of a solid-state image sensing device.

### (Fourth Embodiment)

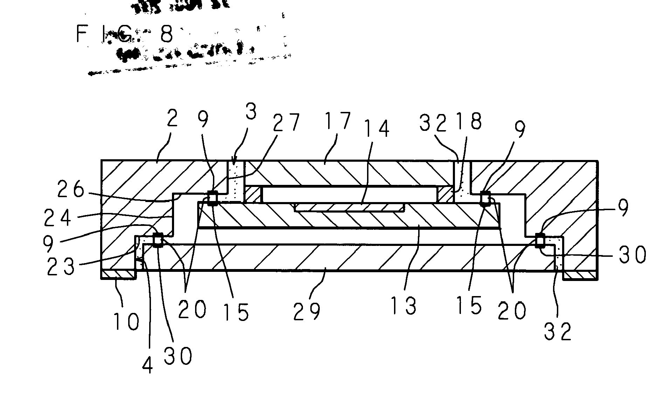

FIG. 8 is a schematic vertical end view showing a fourth embodiment of the present invention. As shown in FIG. 8, a sealing material 32 is filled in space provided between side surfaces of an electronic component 29 and an inner surface 4 of a bore 3. In addition, a sealing material 32 is filled in space provided between an outer surface of an adhesive layer 18 and side surfaces of a light-transmitting lid section 17, and the inner surface 4 of the bore 3. Other components are the same as those in the second embodiment; therefore, the same components are denoted by the same reference numerals and a detailed description thereof is omitted. The sealing material 32 protects bumps 20 and also increases the overall strength of a solid-state image sensing device.

## Claims

1. A solid-state image sensing device, comprising: a printed board (2); a solid-state image sensing element (13) fixed to the printed board (2); and a light-transmitting lid section (17) fixed to the solid-state image sensing element (13) so as to cover an image sensing area (14), **characterized in that**
the printed board (2) has a bore (3) which penetrates through the printed board (2) in a thickness direction thereof, at least a part of the light-transmitting lid section (17) is fitted in the bore (3), and a connecting terminal (9) of the printed board (2) is connected to a connecting terminal (15) of the solid-state image sensing element (13).

2. The solid-state image sensing device according to claim 1, wherein at an inner surface (4) of the bore (3) is formed a flat surface (6) which is parallel to one side of the printed board (2) and on which the connecting terminal (9) of the printed board (2) is provided, and the solid-state image sensing element (13) is fixed to the flat surface (6).

3. The solid-state image sensing device according to claim 2, wherein a sealing material (32) is filled in space provided between side surfaces of the solid-state image sensing element (13) and the light-transmitting lid section (17), and the inner surface (4) of the bore (3).

4. The solid-state image sensing device according to claim 1, wherein at an inner surface (4) of the bore (3) are formed two step-like flat surfaces (23,26) which are parallel to one side of the printed board (2) and on which connecting terminals (9) of the printed board (2) are provided respectively, the solid-state image sensing element (13) is fixed to one (26) of the flat surfaces (23,26) that is further away from the one side, an electronic component (29) is fixed to the other (23) of the flat surfaces (23,26) that is closer to the one side, and a connecting terminal (30) of the electronic component (29) is connected to the connecting terminal (9) of the printed board (2).

5. The solid-state image sensing device according to claim 4, wherein a sealing material (32) is filled in space provided between side surfaces of the electronic component (29) and the light-transmitting lid section (17), and the inner surface (4) of the bore (3).
